# EUROPÄISCHE PATENTSCHRIFT

(11) **EP 1 841 902 B1**
(45) Veröffentlichungstag und Bekanntmachung des Hinweises auf die Patenterteilung: **17.11.2010**
(21) Anmeldenummer: 06707740.4
(22) Anmeldetag: 18.01.2006
(51) Int. Cl.: C30B 25/18, C30B 29/40

(54) **VERFAHREN ZUR HERSTELLUNG VON C-PLANE ORIENTIERTEN GaN- ODER AlxGa1-xN-SUBSTRATEN**
METHOD FOR THE PRODUCTION OF C-PLANE ORIENTED GaN SUBSTRATES OR AlxGa1-xN SUBSTRATES
PROCEDE POUR PRODUIRE DES SUBSTRATS DE GaN OU DE AlxGa1-xN ORIENTES DANS LE PLAN C

(30) Priorität: 24.01.2005 DE 102005003884
(43) Veröffentlichungstag der Anmeldung: 10.10.2007
(73) Patentinhaber: Forschungsverbund Berlin e.V., 12489 Berlin (DE)
(72) Erfinder: RICHTER, Eberhard, 10318 Berlin (DE); TRÄNKLE, Günther, 12557 Berlin (DE); WEYERS, Markus, 15745 Wildau (DE)
(74) Vertreter: Oser, Andreas
(86) Internationale Anmeldenummer: PCT/EP2006/050272
(87) Internationale Veröffentlichungsnummer: WO 2006/077221

(56) Entgegenhaltungen:
- WO-A-2004/084275
- US-A- 5 625 202
- US-A- 6 156 581
- US-B1- 6 218 280
- US-B2- 6 648 966
- WALTEREIT P ET AL: "M-plane GaN(1100) grown on gamma-LiAlO2(100): nitride semiconductors free of internal electrostatic fields" JOURNAL OF CRYSTAL GROWTH, ELSEVIER, AMSTERDAM, NL, Bd. 227-228, Juli 2001 (2001-07), Seiten 437-441, XP004250873 ISSN: 0022-0248
- KE X ET AL: "gamma-LiAlO2 single crystal: a novel substrate for GaN epitaxy" JOURNAL OF CRYSTAL GROWTH, ELSEVIER, AMSTERDAM, NL, Bd. 193, Nr. 1-2, 15. September 1998 (1998-09-15), Seiten 127-132, XP004142226 ISSN: 0022-0248 in der Anmeldung erwähnt
- WALTEREIT ET AL.: "Nitride semiconductors free of electrostatic fields for efficient white light-emitting diodes" NATURE, Bd. 406, 24. August 2000 (2000-08-24), Seiten 865-868, XP002380028 London in der Anmeldung erwähnt

## Beschreibung

Die Erfindung betrifft ein Verfahren zur Herstellung von c-plane GaN- oder AlₓGa₁₋ₓN-Substraten unter Verwendung eines Ausgangssubstrates.

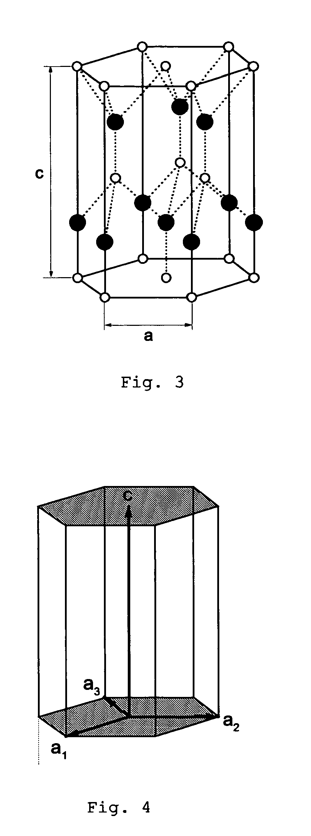

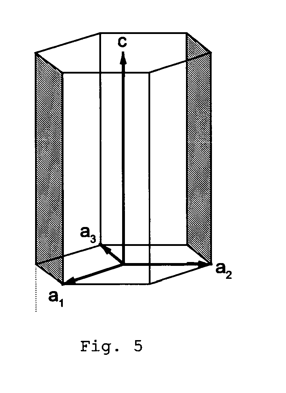

Schichtstrukturen aus Gruppe III-Nitriden (Ga, Al, In) sind die Grundlage für eine Vielzahl von modernen Bauelementen für die Hochfrequenzleistungselektronik (z.B. Nachrichtensysteme auf der Basis von HFETs (heterojunction field effect transistor), Sensorik, strahlungsharte Weltraumelektronik) und für die Optoelektronik (z.B. UV-, blaue und weiße lichtemittierende Dioden (LEDs) und blaue Laserdioden für Beleuchtungs-, Buchdruck-, Display-, Speicher- und Nachrichtenübertragungsanwendungen sowie medizinische Anwendungen). Solche Schichten werden typischerweise mittels Metallorganischer Gasphasenepitaxie (MOVPE) und auch mittels Molekularstrahlepitaxie (MBE) auf einem Ausgangssubstrat hergestellt. Die am häufigsten verwendete Wachstumsrichtung dabei ist die c-Richtung (c-plane Ga(Al, In)N). Fig. 3 zeigt ein Schema des GaN-Gitters mit den Punktlagen für Stickstoff (große, schwarze Kreise) und für Gallium (kleine, offene Kreise), Fig. 4 die Basisvektoren a1 [2-10], a2 [-120] und a3 [-1-10] in der c-Ebene (0001) und des Basisvektors c [001]. Die grau ausgefüllten Flächen zeigen c-Ebenen, die für c-plane orientiertes Wachstum in der Wachstumsebene liegen. Die Wachstumsrichtung ist die [001] Richtung. Die weniger verwendete m-Ebene (m-plane Ga(Al,In)N) unterscheidet sich davon grundsätzlich wegen der resultierenden anderen physikalischen Eigenschaften und Bauelementeigenschaften. Fig. 5 zeigt die Basisvektoren a1 [2-10], a2 [-120] und a3 [-1-10] in der c-Ebene (0001) und den Basisvektor c [001]. Die grau ausgefüllten Flächen zeigen m-Ebenen, die für m-plane orientiertes Wachstum in der Wachstumsebene liegen. Die Wachstumsrichtung ist dann die <1-10> Richtung.

Ein ideales Ausgangssubstrat soll dem gleichen Materialsystem angehören wie die darauf aufgewachsenen Schichten, d.h. im vorliegenden Fall z. B. ein GaN-Substrat sein. Dadurch sind von vornherein die Voraussetzungen für ein defektarmes Wachstum, d.h. eine hinreichend gute bis perfekte Gitterfehlanpassung (Homoepitaxie), und die Anpassung der thermischen Ausdehnungskoeffizienten gegeben. Je nach Anwendung ist eine Dotierung vorteilhaft, die das Substrat n-leitend, semiisolierend oder p-leitend macht.

Im Gegensatz zu anderen Halbleitern, z.B. Silizium (Si) und Galliumarsenid (GaAs), gelingt die Herstellung von GaN-Kristallen mit Durchmessern von 50,8 mm oder mehr durch klassische Einkristallzüchtung bislang nicht. Aussichtsreiche Verfahren wie die Züchtung aus der Schmelze unter hohen Drücken und Temperaturen (HPSG - high pressure solution growth) liefern nur Kristallplättchen in der Dimension von cm². Auch die Züchtung durch Sublimation ist bisher nicht erfolgreich. Bisher werden deshalb die Schichtstrukturen meist auf Fremdsubstrate wie z.B. Saphir und Siliziumcarbid (SiC) epitaktisch gewachsen (Heteroepitaxie). Das ist z.B. bezüglich der erzielbaren Versetzungsdichten und resultierenden Durchbiegungen von Nachteil.

Folglich wurde versucht GaN-Startsubstrate herzustellen, die entweder auf dem Ausgangsmaterial des Startsubstrat verbleiben oder nach dem Wachstum mit einem weiteren Verfahren abgelöst werden.

US 5,625,202 beschreibt das Wachstum von GruppeIII-Nitrid Schichten zur Herstellung von LEDs oder LDs auf einer Vielzahl von verschiedenen Ausgangssubstraten. Diese Ausgangsmaterialien werden als oxidische Verbindungskristalle mit modifizierter Wurtzitstruktur beschrieben und schließen unter anderem auch Lithium Aluminium Oxid ein.
Die GruppeIII-Nitrid-Schichten, z.B. GaN, verbleiben dabei auf dem Ausgangssubstrat. Das führt aufgrund verschiedener thermischer Ausdehnungskoeffizienten stets zu einer starken Verbiegung der Schichten. Es werden keine freistehenden GaN oder AlGaN-Schichten erzeugt.

US 6,156,581 beschreibt das Wachstum von (Ga, Al, In)-Nitridschichten auf einem Fremdsubstrat als Basisschicht für die nachfolgende Herstellung von Bauelementschichtstrukturen mittels MOVPE oder MBE. Gasförmiges (Ga, Al, In)-Chlorid reagiert dazu in einer stickstoffverbindungshaltigen Atmosphäre auf einem Substrat zu (Ga, Al, In)N. Die Schichtdicke kann 2 µm oder mehr betragen. Die Schrift listet eine Anzahl von möglichen alternativen Startsubstraten einschließlich Lithiumaluminat auf. Sie schließt ferner nicht aus, dass unter gewissen Umständen auch das Startsubstrat entfernt werden kann und dann freistehende (Ga, Al, In)N Teile erhalten werden.
Spezifische Wachstumsbedingungen werden jedoch nur für das Wachstum auf Saphir angegeben. Selbst hier ist nicht genau spezifiziert, wie das einkristalline Wachstum auf dem Startsubstrat zustande kommt. Durch den Begriff Lithiumaluminat ist weder die Kristallzusammensetzung (Li₅AlO₄, LiAl₅O₈ oder LiAlO₂), noch die Kristallstruktur (Li₅AlO₄ : orthorhombisch, LiAl₅O₈ : kubisch, LiAlO₂ : orthorhombisch oder tetragonal), noch die notwendige Orientierung angegeben, so dass die Nachvollziehbarkeit nicht gegeben ist.

US 6,218,280 B1 beschreibt das Wachstum von c-plane GaN auf einem Lithium Gallate Substrat (LiGaO₂), wobei zunächst durch MOVPE eine Nitridierung erfolgt und dann ein GaN-Startschicht abgeschieden wird. Dann wird mit HVPE eine weitere GaN-Schicht abgeschieden, die abschließend wieder mit einer MOVPE gewachsenen GaN-Schicht überwachsen wird. Das Ausgangssubstrat kann dann abgelöst sein oder nasschemisch entfernt werden. Die Schrift schlägt eine Reihe weiterer möglicher Ausgangssubstrate u. a. auch orthorhombisches LiAlO₂ vor.
Die Auswahl der Ausgangssubstrate ist auf oxidische Kristalle mit orthorhombischer Struktur beschränkt, wobei spezifische Prozessbedingungen wiederum nur für Lithium Gallate angegeben sind. Der Prozess ist sehr kompliziert und aufwendig, da eine Kombination von MOVPE und HVPE (H-MOVPE) erforderlich ist. Ein direktes Wachstum mittels HVPE wird ausgeschlossen, da in dem Verfahren der Kontakt des Ausgangssubstrates mit Chlorwasserstoffgas (HCl) vermieden werden muss.

Die Artikel von Xu et al. mit den Titeln "γ-LiAlO2 single crystal: a novel substrate for GaN epitaxy" im Journal of Crystal Growth, Vol. 193, 1998, Seiten 127 ff. und "MOCVD Growth of GaN on LiAlO2 Substrates" in Phys. Stat. Sol (a) Vol. 176, 1999, Seiten 589 ff. schlagen die Verwendung eines LiAlO₂ Substrates mit nachfolgender Nitridierung und GaN-Schichtwachstum in der MOVPE vor.
Das MOVPE-Wachstum ist jedoch nicht ausreichend schnell, um damit dickere GaN-Schichten herzustellen wie sie für freistehende GaN-Schichten erforderlich sind.

Nach den Artikeln von Waltereit et al. mit den Titeln "Nitride semiconductors free of electrostatic fields for efficient white light-emitting diodes" in Letters to Nature, Vol. 406, 2000, Seiten 865 ff. und "Growth of M-plane GaN (1-100): A Way to Evade Electrical Polarization in Nitrides" in Phys. Stat. Sol. (a) Vol. 180, 2000, Seiten 133 ff. soll die Abscheidung dünner m-plane orientierter GaN-Schichten auf LiAlO₂ mittels MBE erfolgen. Die Wachstumsraten sind dabei gering (∼0,5 µm/h).
Das Verfahren könnte lediglich Startschichten für das HVPE-Wachstum von m-plane GaN-Schichten ermöglichen. C-plane orientierte GaN-Schichten oder Substrate lassen sich so jedoch nicht herstellen, da die m-plane Orientierung durch die Startschicht vorgegeben wird.

Nach US 6,648,966 B2 erfolgt das Wachstum von m-plane orientierten GaN-Substraten mit Durchmessern von 50 mm und mehr auf tetragonalem γ**-**LiAlO₂ mittels HVPE und die Ablösung des LiAlO₂ in einem nachfolgenden nasschemischen Ätzschritt. Dazu wird zunächst ein Vorbehandlungsschritt mit GaCl und ohne ein stickstoffhaltiges Gas durchgeführt. Nach dem Wachstum verbleibt das LiAlO₂ - Ausgangssubstrat zunächst an der GaN-Schicht und wird dann ex-situ in heißer Salzsäure abgelöst. Das Verfahren erlaubt nicht die Herstellung von c-plane GaN-Substraten. Die so gewonnenen m-plane orientierten Substrate müssen in einem nachfolgenden Ätzschritt abgelöst werden, wodurch Verbiegungen, die während des Abkühlens in die GaN-Schicht eingeprägt werden, erhalten bleiben.

Der Erfindung liegt die Aufgabe zugrunde, ein Verfahren anzugeben, das die einfache Herstellung großflächiger, n- oder p-dotierter, semiisolierend dotierter oder undotierter c-plane GaN- oder AlₓGa₁₋ₓN-Substrate erlaubt.

Erfindungsgemäß wird die Aufgabe gelöst durch die Merkmale des Anspruchs 1. Zweckmäßige Ausgestaltungen sind Gegenstand der Unteransprüche.

Das gesamte Verfahren findet in einer Hydridgasphasenepitaxieanlage (HVPE) für Gruppe III-Nitride statt, die dadurch gekennzeichnet ist, dass eine stickstoffverbindungshaltige Atmosphäre den zum Wachstum und zur Oberflächenstabilisierung erforderlichen Stickstoff auf dem Substrat bereitstellt und ein mittels Chlorwasserstoffgas (HCl) und einem Metall der dritten Hauptgruppe (Al, Ga, In) gebildetes gasförmiges Metallchlorid das zum Wachstum erforderliche Gruppe III-Element auf dem Substrat bereitstellt.
Eine Dotierung kann durch geeignete Ausgangsstoffe realisiert werden, d.h. im einfachsten Falle durch HCl und das entsprechende Element: Silizium (Si) für n-Dotierung, Eisen (Fe) für semiisolierende Dotierung und Magnesium (Mg) für p-Dotierung.

Nach den Verfahrensschritten wird
- tetragonales, (100) oder (-100) orientiertes Lithium Aluminium Oxid (LiAlO₂) als Ausgangssubstrat verwendet. LiAlO₂ ist polymorph und die Kristallstruktur kann mit einer einfachen Röntgenmessung des Winkels 2Thetha am 002 Reflex unterschieden werden: tetragonal: 34.646 Grad; orthorhombisch: 33.929 Grad. Abweichungen der Orientierung der Oberfläche von der exakten Orientierung (sogenannte Fehlorientierung) bis zu einigen Grad werden von dem Verfahren toleriert und führen nur zu Unterschieden in der erreichten Kristallqualität des darauf aufgewachsenen GaN bzw. AlₓGa₁₋ₓN. Das Ausgangssubstrat hat typischerweise einen Durchmesser von 50,8 mm . Das Verfahren ist auf andere Substratgrößen und Substratformen einfach übertragbar.
- Das LiAlO₂ wird in einer stickstoffverbindungshaltigen Atmosphäre bei Temperaturen unterhalb der thermischen Zersetzungstemperatur von LiAlO₂ nitridiert.
   Das heißt, die Temperaturen liegen unterhalb von ca. 900°C, da hier die Verdampfung von Li als LiO₂ deutlich einsetzt.
- Nach der Nitridierung wird die Temperatur für die Bildung einer Keimbildungsschicht eingestellt (ca. 550°C bis 650°C) und durch das Angebot von GaCl in einer stickstoffverbindungshaltigen Atmosphäre GaN-Keime gebildet.
   Diese Temperatur liegt ebenfalls unterhalb der thermischen Zersetzungstemperatur von LiAlO₂. Es werden dabei durch das Angebot von GaCl in der stickstoffverbindungshaltigen Atmosphäre GaN-Keime gebildet, die zu kleinen GaN-Kristalliten auf dem LiAlO₂ heranwachsen. Diese weisen für sich bereits die für das c-plane Wachstum erforderliche (0001) Orientierung in Wachstumsrichtung auf. Die Höhe der Kristallite liegt typischerweise zwischen 10 und 150 nm. Eine solche Startschicht wird kristallografisch allgemein als Nukleationsschicht, Keimbildungsschicht oder gelegentlich auch als Pufferschicht bezeichnet. Der Prozessschritt wird durch Abschalten der GaCl-Zufuhr beendet.
   Die Herstellung des GaCl kann durch Kontakt von HCl und metallischem Gallium bei typischen Temperaturen von 700°C bis 1000°C erfolgen. Der direkte Kontakt des Ausgangssubstrates mit GaCl bzw. ggf. bei der Bildungsreaktion nicht umgesetzten HCl behindert den Prozess nicht.
   Alternativ kann auch eine AlN-Schicht durch die Verwendung von Aluminium statt Gallium oder eine AlₓGa₁₋ₓN-Schicht durch die Verwendung von Aluminium und Gallium erzeugt werden.

Die entstandene Oberfläche wird während der folgenden Verfahrensschritte weiterhin durch eine stickstoffverbindungshaltige Atmosphäre stabilisiert, d.h. die Zersetzung der gebildeten Keimbildungsschicht wird verhindert. Die Keimbildungsschicht schützt zugleich die LiAlO₂ - Oberfläche gegen die Prozessgase des oder der folgenden Schritte.
- Die Temperatur wird für das Wachstum einer dicken GaN- oder AlₓGa₁₋ₓN-Schicht auf 900°C bis 1050°C erhöht, wobei für das Wachstum der Schicht, die durch Zugabe von GaCl, AlCl oder einem Gemisch von GaCl und AlCl erfolgt, hohe Wachstumsraten von typisch 30 µm/h bis 250 µm/h verwendet werden. Erfolgt das Wachstum der dicken Schicht allein bei den angegebenen Temperaturen, ist eine Mindestschichtdicke von ca. 100 µm erforderlich.
   Die Wachstumsrate wird durch die Flussraten von GaCl bzw. AlCl und der Stickstoffverbindung, z.B. Ammoniak (NH₃), gesteuert. Die Mindestschichtdicke ist erforderlich, um im folgenden eine freitragende GaN-Schicht zu erhalten. Die mögliche Schichtdicke oberhalb von 100 µm ist durch das Verfahren nicht begrenzt.
- Die Wachstumstemperatur und die Trägergaszusammensetzung kann während des weiteren Wachstums der GaN- oder AlₓGa₁₋ₓN-Schicht geändert werden, wodurch sich z.B. bei höheren Temperaturen (1000°C bis 1150°C) die kristallinen Eigenschaften des GaN weiter verbessern lassen.
   Die Zugabe von Aluminium oder Indium zur Erzeugung von Mischkristallsubstraten oder von Indium als sogenanntem Surfactant zur Verbesserung der Oberflächenmorphologie ist möglich.
   Eine n-Dotierung des wachsenden Gruppe III-Nitrids kann durch die Reaktion von Silizium mit Chlorwasserstoffgas oder besonders einfach durch die Zugabe der siliziumhaltigen Verbindung Dichlorsilan (Cl₂SiH₂) erreicht werden.
   Eine p-Dotierung des wachsenden Gruppe III-Nitrids kann durch die Reaktion von Magnesium Mg mit Chlorwasserstoffgas oder durch die Zugabe einer magnesiumhaltigen Verbindung, z.B. Biscyclopentadienylmagnesium (Cp₂Mg: Mg(C₅H₅)₂), in die Gasphase erreicht werden.
   Eine Dotierung des wachsenden Gruppe III-Nitrids zur Erzielung semiisolierender elektrischer Eigenschaften kann durch die Reaktion von Eisen (Fe) mit Chlorwasserstoffgas oder durch die Zugabe einer eisenhaltigen Verbindung, z.B. Biscyclopentadienyleisen (Ferrocen: Cp₂Fe: Fe(C₅H₅)₂), in die Gasphase erreicht werden.
   Die Verwendung eines Dotiergases gegenüber einer Feststoffquelle vereinfacht das Verfahren, da ein Dotiergas kontinuierlich gesteuert werden kann.

Da die Wachstumstemperatur oberhalb der Stabilitätstemperatur von LiAlO₂ von ca. 900°C liegt, beginnt ein Zersetzungsprozess des Ausgangssubstrates bereits während des GaN-Wachstums. Die hohe Wachstumsgeschwindigkeit der HVPE ist demnach für das Verfahren wichtig. Dieser Zersetzungsprozess unter Freisetzung von Lithium führt zu einer Verringerung der mechanischen Stabilität des Ausgangssubstrates und einer Schwächung der Bindung zwischen GaN-Schicht bzw. AlₓGa₁₋ₓN-Schicht und LiAlO₂.
- Der Zersetzungsprozess kann durch die Zugabe von Wasserstoff ins Trägergas oder durch Temperaturerhöhung bis zu 1200°C beschleunigt werden.
   Insbesondere kann dieser Schritt zur Beschleunigung der insitu Trennung des Ausgangssubstrates LiAlO₂ nach dem eigentlichen Wachstum des GaN bzw. AlₓGa₁₋ₓN in der stickstoffverbindungshaltigen Atmosphäre durchgeführt werden.
   Wasserstoff hat die Eigenschaft, Rissbildungen beim Wachstum des GaN bzw. AlₓGa₁₋ₓN zu verringern bzw. zu vermeiden, jedoch auf das LiAlO₂-Ausgangssubstrat zerstörend zu wirken.
- Das Verfahren schließt mit dem Abkühlen der GaN-Schicht bzw. der AlₓGa₁₋ₓN-Schicht und des Ausgangssubstrates ab. Dabei trennen sich die GaN-Schicht bzw. die AlₓGa₁₋ₓN-Schicht und das LiAlO₂-Ausgangssubstrat endgültig, wobei das LiAlO₂-Ausgangssubstrat in Streifen reißt. Infolge der Trennung wird in die dann freistehende GaN-Schicht bzw. freistehende AlₓGa₁₋ₓN-Schicht keine Verbiegung durch die unterschiedlichen thermischen Ausdehnungskoeffizienten von Substrat und Schicht eingeprägt.

Die erhaltene freistehende GaN-Schicht bzw. AlₓGa₁₋ₓN-Schicht kann als GaN-Substrat bzw. AlₓGa₁₋ₓN-Substrat für das Wachstum von Gruppe III-Nitrid-Schichtstrukturen in der MOVPE oder in der MBE oder durch die Aufbringung metallischer Kontakte zur Herstellung von elektronischen oder optoelektronischen Bauelementen weiterverwendet werden. Dazu kann die Oberfläche poliert werden. Das GaN-Substrat bzw. das AlₓGa₁₋ₓN-Substrat kann auch als Startschicht für das weitere Wachstum von Gruppe III-Nitriden mit der HVPE genutzt werden.

Das Verfahren zeichnet sich durch seine Einfachheit aus und die Verwertung ist dadurch technologisch besonders interessant. Die Einfachheit besteht darin, dass für das gesamte Verfahren nur eine HVPE-Anlage mit vergleichsweise preiswerten Ausgangsstoffen benötigt wird und dass keine nachfolgenden Schritte zur Ablösung des Ausgangssubstrates erforderlich sind.

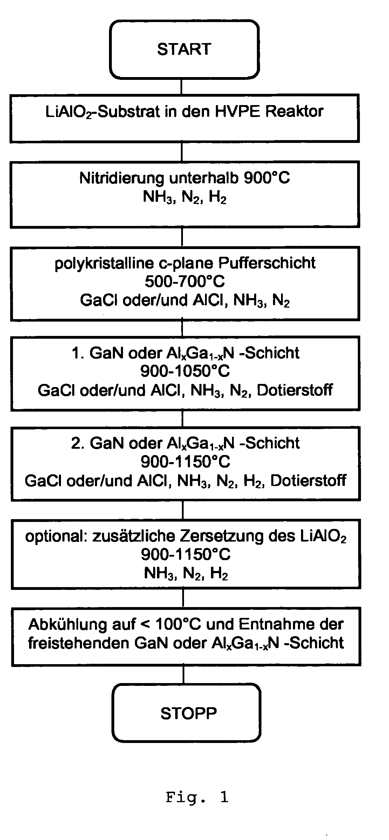

Die Erfindung soll nachstehend anhand eines Ausführungsbeispiels näher erläutert werden. Die zugehörigen Zeichnungen zeigen
- Fig. 1: ein Flussdiagramm des Verfahrens,

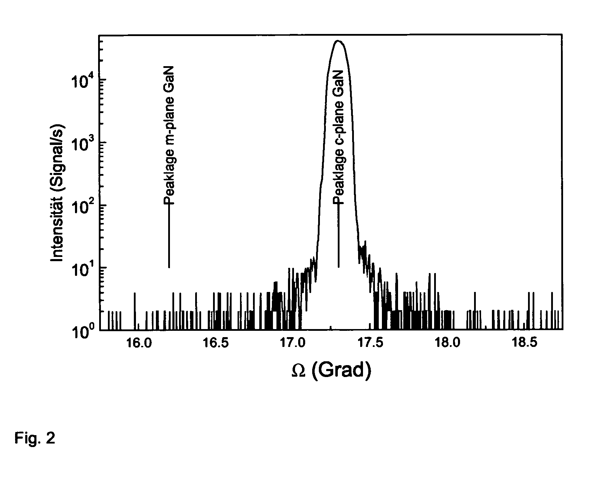

- Fig. 2: die Omega-Rockingkurve des 002 Reflexes einer nach dem erfindungsgemäßen Verfahren hergestellten freistehenden GaN-Schicht mit dem Nachweis der c-plane Orientierung, wobei zur Verdeutlichung die im Falle einer m-plane orientierten GaN-Schicht zu erwartende Peaklage gekennzeichnet ist,
- Fig. 3: ein Schema des GaN-Gitters,
- Fig. 4: die Basisvektoren des GaN-Gitters und die c-Ebenen und
- Fig. 5: die Basisvektoren des GaN-Gitters und die m-Ebenen.

Mit dem Verfahren wird beispielsweise eine freistehende, c-plane orientierte GaN-Schicht mit einem Durchmesser von 50,8 mm hergestellt. Verwendet wird ein kommerzieller, horizontaler HVPE-Reaktor. Das LiAlO₂-Substrat wird in den Reaktor eingelegt. Der Substrathalter rotiert. Der Reaktordruck wird auf 800 hPa eingestellt und die Temperatur auf 850°C eingestellt. Die Nitridierung wird mit einer Dauer von 10 min durchgeführt. Die stickstoffverbindungshaltige Atmosphäre wurde durch ein Gemisch von Ammoniak (600 ml/min), Stickstoff und Wasserstoff realisiert. Anschließend wird bei reiner Stickstoffatmosphäre die Substrattemperatur auf 600°C abgesenkt. Durch Zugabe von NH₃ (500 ml/min) und HCl (10 ml/min), das mit Gallium zu GaCl reagiert, wird die GaN-Keimbildungsschicht innerhalb von 7 min gewachsen. Dieser Wachstumsschritt wird durch Abschalten der Einleitung von HCl beendet. Der Reaktordruck wird in diesem Falle auf 200 hPa abgesenkt und die Temperatur auf 1000°C erhöht. Eine Fortführung des Prozesses bei einem anderen Druck, z.B. unverändert 800 hPa, ist ebenso möglich. Dann wird zunächst eine erste, einkristalline GaN-Schicht in Stickstoffatmosphäre mit Flussraten von 500 ml/min für NH₃ und 30 ml/min für HCl gewachsen. In diesem Fall ist diese GaN-Schicht ca. 20 µm dick. Daran anschließend wird die Temperatur auf 1010°C und der HCl-Fluss auf 100 ml/min bei gleichem NH₃-Fluß erhöht und das Wachstum für 60 min unter Zugabe von Wasserstoff fortgesetzt. Die GaN-Schicht und das Substrat werden dann abgekühlt. Bei ca. 700°C wird die Einleitung von NH₃ abgeschaltet. Die dann 160 µm dicke, freistehende GaN-Schicht (Das LiAlO₂-Substrat hat sich dann selbst abgetrennt) wird aus dem Reaktor entnommen und die LiAlO₂-Reste verworfen.

## Patentansprüche

1. Verfahren zur Herstellung von c-plane orientierten GaN- oder AlₓGa₁₋ₓN-Substraten unter Verwendung eines Ausgangssubstrats,
**gekennzeichnet durch** die folgenden Schritte:
- Verwendung eines tetragonalen (100) oder (-100) orientierten LiAlO₂-Ausgangssubstrates
- Nitridierung in einer stickstoffverbindungshaltigen Atmosphäre bei Temperaturen unterhalb der Zersetzungstemperatur von LiAlO₂
- Wachstum einer Keimbildungsschicht bei Temperaturen von 500°C bis 700°C **durch** Zugabe von GaCl oder AlCl oder einem Gemisch von GaCl und AlCl in einer stickstoffverbindungshaltigen Atmosphäre
- Wachstum von einkristallinem, c-plane orientierten GaN oder AlₓGa₁₋ₓN auf der Keimbildungsschicht bei Temperaturen im Bereich zwischen 900°C und 1050°C **durch** Hydridgasphasenepitaxie (HVPE) mit GaCl oder AlCl oder einer GaCl/AlCl-Mischung in einer stickstoffverbindungshaltigen Atmosphäre
- Abkühlen des Substrats.

2. Verfahren zur Herstellung von c-plane orientierten GaN- oder AlₓGa₁₋ₓN-Substraten gemäß Anspruch 1, **dadurch gekennzeichnet, dass** ein weiterer Wachstumsschritt zur Abscheidung von c-plane orietiertem GaN- oder AlₓGa₁₋ₓN-Schicht durch HVPE mit einer Gesamtdicke von mindestens 100 µm bei Temperaturen zwischen 1000 und 1150 °C nach dem Wachstumschritt bei 900 bis 1050°C und vor dem Abkühlen des Substrates erfolgt.

3. Verfahren nach Anspruch 1 oder 2, **gekennzeichnet durch** eine Wachstumsrate von mindestens 30 µm/h beim Wachstum der dicken GaN- oder AlₓGa₁₋ₓN-Schicht.

4. Verfahren nach einem der Ansprüche 1 bis 3, **gekennzeichnet durch** Wasserstoffzugabe während oder nach dem Wachstum der dicken GaN- oder AlₓGa₁₋ₓN-Schicht.

5. Verfahren nach Anspruch 1 oder 2, **gekennzeichnet durch** weitere Temperaturerhöhung bis maximal 1200°C nach dem Wachstum der dicken GaN- oder AlₓGa₁₋ₓN-Schicht in einer stickstoffverbindungshaltigen Atmosphäre.

6. Verfahren nach einem der vorhergehenden Ansprüche, **gekennzeichnet durch** eine Zugabe von Aluminium (Al) oder Indium (In) während des Wachstums der dicken GaN- oder AlₓGa₁₋ₓN-Schicht.

7. Verfahren nach einem der vorhergehenden Ansprüche 1 bis 6, **dadurch gekennzeichnet, dass** eine n-Typ Dotierung mittels Dichlorsilan (Cl₂SiH₂) erfolgt.

8. Verfahren nach einem der vorhergehenden Ansprüche 1 bis 6, **dadurch gekennzeichnet, dass** eine p-Typ Dotierung mittels Magnesium (Mg bzw. Mg(C₅H₅)₂) erfolgt.

9. Verfahren nach einem der vorhergehenden Ansprüche 1 bis 6, **dadurch gekennzeichnet, dass** eine semiisolierende Dotierung mittels Eisen (Fe bzw. Fe(C₅H₅)₂) erfolgt.

10. Verwendung eines nach dem Verfahren gemäß einem der vorhergehenden Ansprüche hergestellten Substrats für eine nachfolgende Abscheidung mindestens einer weiteren Schicht mittels MOVPE oder MBE zur Herstellung elektronischer oder optoelektronischer Bauelemente oder zur weiteren Verwendung als Substrat in der HVPE.

11. Verwendung eines nach dem Verfahren gemäß einem der Ansprüche 1 bis 9 hergestellten Substrats zur Herstellung eines elektronischen oder optoelektronischen Bauelements durch Aufbringung mindestens eines metallischen Kontaktes.

12. Verwendung eines nach dem Verfahren gemäß einem der Ansprüche 1 bis 9 hergestellten Substrats für eine nachfolgende Abscheidung durch HVPE von weiteren GaN- oder AlₓGa₁₋ₓN-Schichten zur Herstellung dickerer GaN- oder AlₓGa₁₋ₓN-Schichten oder GaN- oder AlₓGa₁₋ₓN-Einkristalle, die nachfolgend z.B. durch Sägen vereinzelt werden zur Herstellung elektronischer oder optoelektronischer Bauelemente oder zur weiteren Verwendung als Substrat in der HVPE.

## Claims

1. Process for producing c-plane oriented GaN- or AlₓGa₁₋ₓN-substrates, using a starting substrate, **characterized by** the following steps:
- use of a tetragonal (100) or (-100) oriented LiAlO₂ starting substrate,
- nitridation in a nitrogen compound-containing atmosphere at temperatures below the decomposition temperature of LiAlO₂,
- growth of a nucleation layer at temperatures from 500°C to 700°C by supplying GaCl or AlCl or a mixture of GaCl and AlCl in a nitrogen compound-containing atmosphere,
- growth of a single-crystalline, c-plane oriented GaN or AlₓGa₁₋ₓN on the nucleation layer at temperatures in the range of between 900°C and 1050°C by hydride vapor phase epitaxy (HVPE) with GaCl or AlCl or a mixture of GaCl/AlCl in a nitrogen compound-containing atmosphere,
- cooling the substrate.

2. Process for producing c-plane oriented GaN- or AlₓGa₁₋ₓN-substrates according to claim 1, **characterized in that**, after the growth step at 900 to 1050°C and before cooling the substrate, a further growth step is carried out for depositing c-plane oriented GaN- or AlₓGa₁₋ₓN-layer by HVPE with a total thickness of at least 100 µm at temperatures between 1000 and 1150 °C.

3. Process according to claim 1 or 2, **characterized by** a growth rate of at least 30 µm/h during the growth of the thick GaN- or AlₓGa₁₋ₓN-layer.

4. Process according to one of claims 1 to 3, **characterized by** a hydrogen addition during or after the growth of the thick GaN- or AlₓGa₁₋ₓN-layer.

5. Process according to claims 1 to 2, **characterized by**, after the growth of the thick GaN- or AlₓGa₁₋ₓN-layer, a further temperature increase up to maximally 1200°C in a nitrogen compound-containing atmosphere.

6. Process according to one of the preceding claims, **characterized by** an addition of aluminum (Al) or indium (In) during the growth of the thick GaN- or AlₓGa₁₋ₓN-layer.

7. Process according to one of the preceding claims 1 to 6, **characterized in that** a n-type doping is carried out by means of dichlorosilane (Cl₂SiH₂).

8. Process according to one of the preceding claims 1 to 6, **characterized in that** a p-type doping is carried out by means of magnesium (Mg or Mg(C₅H₅)₂).

9. Process according to one of the preceding claims 1 to 6, **characterized in that** a semi-insulating doping is carried out by means of iron (Fe or Fe(C₅H₅)₂).

10. Use of a substrate produced by a process according to one of the preceding claims for a subsequent deposition of at least one further layer by MOVPE or MBE for the manufacture of electronic or opto-electronic devices, or for further use as substrate in HVPE.

11. Use of a substrate produced by a process according to one of claims 1 to 9 for the manufacture of an electronic or opto-electronic device by applying at least one metal contact.

12. Use of a substrate produced by a process according to one of claims 1 to 9 for the subsequent deposition, by HVPE, of further GaN- or AlₓGa₁₋ₓN-layers for the manufacture of thicker GaN- or AlₓGa₁₋ₓN-layers or GaN- or AlₓGa₁₋ₓN-single crystals, which are subsequently individualized e.g. by sawing, for the manufacture of electronic or opto-electronic devices, or for further use as substrate in HVPE.

## Revendications

1. Procédé pour produire des substrats de GAN ou de ALₓGA₁₋ₓN orientés dans le plan c, avec utilisation d'un substrat initial,
**caractérisé par** les étapes suivantes :
- utilisation d'un substrat initial de LiAlO₂ tétragonal à orientation (100) ou (-100),
- nitruration dans une atmosphère contenant des composés azotés, à des températures inférieures à la température de décomposition du LiAlO₂,
- mise en croissance d'une couche de formation de germes, à des températures dans la fourchette comprise entre 500°C et 700°C, par addition de GaCl ou d'AlCl, ou d'un mélange de GaCl et d'AlCl, dans une atmosphère contenant des composés azotés,
- mise en croissance de GAN ou de ALₓGA₁₋ₓN orienté dans le plan c, monocristallin, sur la couche de formation de germes, à des températures dans la fourchette comprise entre 900°C et 1050°C, par épitaxie en phase vapeur aux hydrures (HPVE) avec GaCl ou d'AlCl, ou un mélange de GaCl/AlCl dans une atmosphère contenant des composés azotés,
- refroidissement du substrat.

2. Procédé pour produire des substrats de GAN ou de ALₓGA₁₋ₓN orientés dans le plan C selon la revendication 1, **caractérisé en ce qu'**une étape de croissance supplémentaire, de déposition de couche de GAN ou de ALₓGA₁₋ₓN orienté dans le plan c, par HPVE, d'une épaisseur globale d'au moins 100 µm, est effectuée à des températures dans la fourchette comprise entre 1000°C et 1050°C, après l'étape de mise en croissance, à 900 à 1050°C, et avant l'étape de refroidissement du substrat.

3. Procédé selon la revendication 1 ou 2, **caractérisé par** un taux de croissance d'au moins 30 µm/h, lors de la mise en croissance de la couche épaisse de GAN ou de ALₓGA₁₋ₓN.

4. Procédé selon l'une des revendications 1 à 3, **caractérisé par** une addition d'hydrogène, pendant ou après la mise en croissance de la couche épaisse de GAN ou de ALₓGA₁₋ₓN.

5. Procédé selon la revendication 1 ou 2, **caractérisé par** une augmentation de température supplémentaire, jusqu'à un maximum de 1200°C, après la mise en croissance de la couche épaisse de GAN ou de ALₓGA₁₋ₓN dans une atmosphère contenant des composés azotés.

6. Procédé selon l'une des revendications précédentes, **caractérisé par** une addition d'aluminium (Al) ou d'indium (In), pendant la mise en croissance de la couche épaisse de GAN ou de ALₓGA₁₋ₓN.

7. Procédé selon l'une des revendications 1 à 6 précédentes, **caractérisé en ce qu'**un dopage de type n est effectué au moyen de dichlorosilane (Cl₂SiH₂).

8. Procédé selon l'une des revendications 1 à 6 précédentes, **caractérisé en ce qu'**un dopage de type p est effectué au moyen de magnésium (Mg ou Mg(C₅H₅)₂).

9. Procédé selon l'une des revendications 1 à 6 précédentes, **caractérisé en ce qu'**un dopage de type semi-isolant est effectué au moyen de fer (Fe ou Fe(C₅H₅)₂).

10. Utilisation d'un substrat fabriqué suivant le procédé selon l'une des revendications précédentes, pour une déposition subséquente d'au moins une couche supplémentaire, au moyen d'une épitaxie en phase vapeur aux organométallliques (MOVPE) ou d'une épitaxie par jets moléculaires (MBE), pour fabriquer des composants électroniques ou optoélectroniques ou pour utilisation subséquente comme substrat dans la HPVE.

11. Utilisation d'un substrat fabriqué suivant le procédé selon l'une des revendications 1 à 9 précédentes, pour la fabrication d'un composant électronique ou optoélectronique, par application d'au moins un contact métallique.

12. Utilisation d'un substrat fabriqué suivant le procédé selon l'une des revendications 1 à 9 précédentes, pour une déposition subséquente, par HPVE, d'autres couches de GAN ou de ALₓGA₁₋ₓN pour la fabrication de couches de GAN ou de ALₓGA₁₋ₓN plus épaisses ou de monocristaux de GAN ou de ALₓGA₁₋ₓN, individualisés subséquemment, par exemple par sciage, pour fabriquer des composants électroniques ou optoélectroniques ou pour utilisation subséquente comme substrat dans la HPVE.
